# EUROPEAN PATENT APPLICATION

(11) **EP 4 668 314 A1**
(43) Date of publication of application: **24.12.2025**
(21) Application number: 24305951.6
(22) Date of filing: 17.06.2024
(51) Int. Cl.: H01L 21/02, H01L 29/06

(54) **AN ELECTRICAL DEVICE FOR MEASURING AN ELECTRICAL PARAMETER OF A CONDUCTIVE LAYER TO BE CHARACTERIZED INCLUDING MULTIPLE 2D CAPACITORS**

(71) Applicant: pSemi Corporation, San Diego, CA 92121 (US)
(72) Inventor: VOIRON, Frédéric, 14000 CAEN (FR); SOULIER, Brigitte, 14000 CAEN (FR); SALLAZ, Valentin, 14000 CAEN (FR); CANDRA, Panglijen, San Diego 92121 (US); KOUASSI, Sébastien, San Diego 92121 (US)
(74) Representative: Cabinet Beau de Loménie

(57) **Abstract**

A method for manufacturing an integrated device, comprising:
providing a support (100) having a first conductive via (102) coming out on a face (F1) of the support so as to be flush with the face of the support, the via being surrounded by an insulating region (103) at the level of said face,
forming an anodization barrier region (204) above said face of the support, the anodization barrier layer being in electrical contact with the via,
forming a region (202) of anodizable material above the anodization barrier region and above the conductive via,
anodizing the region of anodizable material to obtain a porous region (210) comprising straight vertical pores (POR) extending from a top surface of the region to reach the anodization barrier region,
forming, within the porous region, a second conductive via (220) extending between the top surface of the porous region and the anodization barrier region, so as to form an electrical connection between the conductive via and the top surface of the porous region.

## Description

### Field of the Invention

The present invention relates to the field of integration and, more particularly, to integrated devices and their manufacture, in particular integrated devices acting as interposers.

### Technical Background

There exist new applications requiring novel interposer arrangements. In particular, some applications require the use of interposers having integrated thereon components and in particular integrated capacitors. High Performance Computing (HPC) is one such new application that requires the presence of decoupling capacitors between cores.

When implemented within an interposer, integrated components have to comply with manufacturing processes that allow vertical integration, with bottom and top connections, which are typically realized using through vias. This renders complex the integration of various components such as capacitors within interposers.

Recent advances in the field of capacitor manufacturing technologies will now be described.

In their work titled "Nanotubular metal-insulator-metal capacitor arrays for energy storage" (published in Natural technology, May 2009), P. Banerjee *et al.* describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material. Banerjee's PAA embedded structure however suffers from high Equivalent Series Resistance (ESR) and limited capacitance density due to the PAA thickness that can be deposited by Atomic Layer Deposition (ALD).

A structure by F. Voiron *et al.* that improves Banerjee's ESR and capacitance is described in international application publication WO 2015/063420 A1. Voiron's structure results in highly integrated capacitance that may be used in a variety of applications. In this structure the bottoms of the pores are opened and the lower metal layer of the MIM structure contacts a conductive layer that underlies the porous region, providing electrical contact and reducing ESR.

Generally, PAA embedded structures as described above result from embedding a structure (e.g., a MIM capacitive stack) inside a porous region above a substrate, such as a silicon wafer. Typically, the porous region results from anodizing a thin layer of metal, such as aluminium, deposited above the substrate. The anodization converts the aluminium layer into porous anodic alumina. Typically, the porous region is formed with any shape (as viewed from the top) and extends across the alumina layer in a direction perpendicular to the wafer surface.

Above the porous structure and inside the pores, a stack of materials is formed in a conformal manner including:
- A bottom capacitor electrode layer (typically titanium nitride: TiN),
- A dielectric layer (typically a combination of Oxide layers),
- A top capacitor electrode layer (typically titanium nitride: TiN)

A 3D capacitor is formed by this stack. It is desirable to implement such capacitors within interposer devices.

It is also known to accommodate conductive wires within pores of a porous alumina region, as described in document EP4009340. In particular, this document discloses an arrangement in which a porous alumina region accommodates a first group of pores filled with conductive wires, and a second group of pores accommodates a MIM structure (Metal-Insulator-Metal).

It is also desirable to accommodate such conductive wires within interposer devices.

The structure such as the one of document EP4009340 remains difficult to accommodate within a device such as an interposer, with vertical vias.

The present invention has been made in the light of the above problems.

### Summary of the Invention

The present invention provides a method for manufacturing an integrated device, comprising:
providing a support having a first conductive via (for example a through silicon via) coming out on a face of the support so as to be flush with the face of the support (the face of the support is planar and a zone of this face comprises the conductive material of the via), the via being surrounded by an insulating region at the level of said face (i.e. when the face is observed from the top, a zone of conductive material corresponding to the via is surrounded by insulating material of the insulating region),
forming an anodization barrier region above said face of the support, the anodization barrier layer being in electrical contact with the via,
forming a region of anodizable material above the anodization barrier region and above the conductive via,
anodizing the region of anodizable material to obtain a porous region comprising straight vertical pores extending from a top surface of the region to reach the anodization barrier region,
forming, within the porous region, a second conductive via extending between the top surface of the porous region and the anodization barrier region, so as to form an electrical connection between the conductive via and the top surface of the porous region (i.e. the second conductive via is present where initially there was a group of pores of the porous region).

The anodization barrier layer, for example tungsten, can be selected to be electrically conductive. This leads the first conductive via to be connected to the second conductive via. Consequently, a vertical connection is obtained between at least the top of the porous region and the extremity of the first conductive via opposite to said face of the support.

In the above method, the first conductive via is manufactured before forming the anodization barrier region and before performing the anodization.

This particular sequence of steps has been observed to facilitate the manufacture of components within the porous region, and can be referred to as a "via first" process. In particular, the sequence of steps facilitates implementing a MIM stack within the pores of the porous region.

According to a particular embodiment, forming the second conductive via comprises forming conductive nanowires within pores of a first group of pores of the porous region (i.e. each pore of the first group of pores comprises a conductive nanowire, the pores typically having an average pore diameter of the order of tens of nanometers).

In this particular embodiment, the second conductive via comprises a plurality of conductive nanowires that are filled with conductive material to obtain nanowires. By way of example, the techniques used in this particular embodiment can be analogous to the ones used in document EP4009340.

According to a particular embodiment (which is an alternative to the previous embodiment), forming the second conductive via comprises removing pores of a first group of pores of the porous region by etching to obtain a cavity (this cavity occupies the position of the pores of the first group of pores), and filling (at least partially) the cavity with an electrically conductive material.

In this particular embodiment, the pores of the first group of pores have been replaced, this means that the etching has replaced the porous material defining the pores. The etching is performed so that the cavity opens onto the anodization barrier region.

According to a particular embodiment, the porous region comprises first surrounding pores around the second conductive via forming an insulating region around the second conductive via.

In this particular embodiment, pores, which are anodized material typically insulating, are not filled with a conductive material or are left empty so as to provide a lateral insulation around the second conductive via.

According to a particular embodiment, the method comprises forming another anodization barrier region above said face of the support, electrically disconnected from said anodization barrier region.

Forming the two anodization barrier region (i.e. the anodization barrier region and the another anodization barrier region (i.e. a second anodization barrier region)) can be implemented by depositing a layer of anodization barrier material, and subsequently patterning this layer by photolithography to obtain the two regions. An insulating material can be deposited in the regions opened by the patterning.

Also, while the anodization barrier region is electrically connected to the first conductive via, the another anodization barrier region, which is electrically disconnected from the anodization barrier region, is also disconnected from the first conductive via. This can be obtained by forming the another anodization barrier region above the insulating region of the face of the support.

According to a particular embodiment, the method comprises forming a stacked structure within a second group of pores of the porous region, wherein the stacked structure comprises a bottom electrode layer in electrical contact at the bottom of pores of the second group of pores with the anodization barrier region or with the another anodization barrier region, an intermediate layer on the bottom electrode layer, and a top electrode layer on the intermediate layer.

The stacked structure can be a MIM, so as to form a capacitor. The layers can each be deposited in a conformal manner inside the pores, for example by Atomic Layer Deposition (ALD), and the thickness of the three layers can be selected to be less than half of the average pore diameter of the porous region.

It appears that the bottom electrode of the structure is electrically connected to the anodization barrier layer in a first variant, which implies that the bottom electrode layer is also connected to the first conductive via and to the second conductive via. This allows reaching the bottom electrode layer of the stacked structure from the top of the porous region, and also from the other extremity of the first conductive via.

In a second variant, the bottom electrode of the structure is electrically connected to the another anodization barrier layer, which implies that the bottom electrode layer is also disconnected from the first conductive via and from the second conductive via. In this variant, other first and second conductive vias may be used with a structure which is analogous to the ones mentioned above.

The intermediate layer can be a layer of dielectric material or a layer of electron blocking material having polarization properties. For example, the intermediate layer can be an ionic conductor which is also a dielectric.

According to a particular embodiment, the porous region comprises second surrounding pores around the stacked structure forming an insulating region.

In a manner which is similar to the surrounding pores around the second conductive via, surrounding pores left empty or filed with insulating material can surround the stacked structure to obtain a lateral insulation.

According to a particular embodiment, providing the support comprises providing a preliminary support having a preliminary first conductive via coming out on a face of the preliminary support so as to be flush with the face of the preliminary support, the via being surrounded by an insulating region at the level of said face,
forming an additional insulating region on the face of the preliminary support having an opening that opens onto the preliminary first conductive via, and filling the opening with a conductive material, the preliminary first conductive via and the conductive material filling the opening forming the first conductive via.

The preliminary first conductive via may comprise a material such as copper that may migrate within the device, in particular during subsequent process steps requiring a large thermal budget (for example the MIM deposition processes).

The additional insulating region (and the conductive material filling the opening) can comprise materials selected to prevent this migration and to act as a barrier. In fact, at the level of the face of the preliminary support, the preliminary first conductive via is covered by the conductive material (at the level of the opening) and eventually by the additional insulating region (in particular if the perimeter of the preliminary first conductive via is not comprised in the opening (i.e. when observed from the top, the preliminary first conductive via appears to be not completely within the opening)).

With an appropriate conductive material selected for filling the opening, migration of the material of the preliminary first conductive via is prevented.

While the first conductive via may have a cylindrical shape (with any base) when going through the preliminary support, in this embodiment, it may be desirable to form a conductive layer that routes the signals from the first conductive via within the device. Here, this is done within the support, with the conductive material formed above the preliminary via, and this conductive material may extend horizontally to route signals (it is however also a part of the first conductive via).

According to a particular embodiment, forming the anodization barrier region comprises forming, on said face of the support, another additional insulating region (which differs from the additional insulating region of the previous embodiment and from the insulating region of the support) having an opening that opens onto the first conductive via, and depositing a layer of anodization barrier material on the another additional insulating region and inside the opening of the another additional insulating region to obtain the anodization barrier region.

The first conductive via (like the preliminary first conductive via mentioned above) may comprise a material such as copper that may migrate within the device, in particular during subsequent process steps requiring a large thermal budget (for example the MIM deposition processes). In this particular embodiment, the another additional insulating region can comprise a material selected to prevent migration of the material of the first conductive via. The material of the anodization barrier layer filling the opening in the another additional insulating region may also be selected so prevent migration of the material of the first conductive via.

This embodiment also allows having an anodization barrier layer which is separate from the face of the support except where there is an opening. This is particularly useful when the support comprises a material such as silicon around the insulating region.

According to a particular embodiment, the method comprises performing a planarizing to obtain said face of the support.

This particular embodiment facilitates the subsequent depositions and in particular ensures that a good planarity (i.e. an absence of topology) is obtained after the anodizing has been performed. Planarizing to obtain the face of the support can be performed for any one of the above defined embodiments.

The invention also provides an integrated device comprising:
a support having a first conductive via coming out on a face of the support so as to be flush with the face of the support, the via being surrounded by an insulating region at the level of said face,
an anodization barrier region above said face of the support, the anodization barrier layer being in electrical contact with the via,
a porous region above the anodization barrier region comprising straight vertical pores extending from a top surface of the region to reach the anodization barrier region,
within the porous region, a second conductive via extending between the top surface of the porous region and the anodization barrier region, so as to form an electrical connection between the conductive via and the top surface of the porous region.

This integrated device may be referred to as an interposer.

This integrated device may be obtained by any embodiment of the above defined method.

According to a particular embodiment, the second conductive via comprises conductive nanowires within pores of a first group of pores of the porous region.

According to a particular embodiment, the second conductive via comprises a cavity having a width which is greater than a pore of the porous region, filled with an electrically conductive material.

According to a particular embodiment, the porous region comprises first surrounding pores around the second conductive via forming an insulating region around the second conductive via.

According to a particular embodiment, the integrated device comprises another anodization barrier region above said face of the support, electrically disconnected from said anodization barrier region.

According to a particular embodiment, the integrated device comprises a stacked structure within a second group of pores of the porous region, wherein the stacked structure comprises a bottom electrode layer in electrical contact at the bottom of pores of the second group of pores with the anodization barrier region or with the another anodization barrier region, an intermediate layer on the bottom electrode layer, and a top electrode layer on the intermediate layer.

According to a particular embodiment, the porous region comprises second surrounding pores around the stacked structure forming an insulating region.

According to a particular embodiment, the support comprises a preliminary support having a preliminary first conductive via coming out on a face of the preliminary support so as to be flush with the face of the preliminary support, the via being surrounded by an insulating region at the level of said face,
and an additional insulating region on the face of the preliminary support having an opening comprising the perimeter of the preliminary first conductive via, the opening being filled with a conductive material, the preliminary first conductive via and the conductive material filling the opening forming the first conductive via.

According to a particular embodiment, the integrated device comprises, on said face of the support, another additional insulating region having an opening that opens onto the first conductive via, and a layer of anodization barrier material on the another additional insulating region and inside the opening of the another additional insulating region, forming the anodization barrier region.

### Brief Description of the Drawings

Further features and advantages of the present invention will become apparent from the following description of certain embodiments thereof, given by way of illustration only, not limitation, with reference to the accompanying drawings in which:
- Figure 1 is a schematic representation of a support according to an example,
- Figure 2 shows an anodizable layer formed above the support of figure 1,
- Figure 3 shows the structure of figure 2 after anodizing,
- Figure 4 shows the structure of figure 3 after a second conductive via and a MIM stack have been formed,
- Figure 5 shows in more detail a pore comprising the MIM stack,
- Figure 6 shows an integrated device according to another example,
- Figure 7 shows an integrated device according to another example,
- Figure 8 shows an integrated device according to another example,
- Figure 9 shows an integrated device according to another example, and
- Figure 10 shows an integrated device according to another example.

### Detailed Description of Example Embodiments

We will now describe a method of manufacturing an integrated device, this device comprising electrically conductive vias. This integrated device can be used as an interposer and is particularly suitable for use in HPC applications.

Also, the device is manufactured in a "via first" configuration, where a conductive via has already been formed when subsequently, components such as another conductive via or a capacitor are formed.

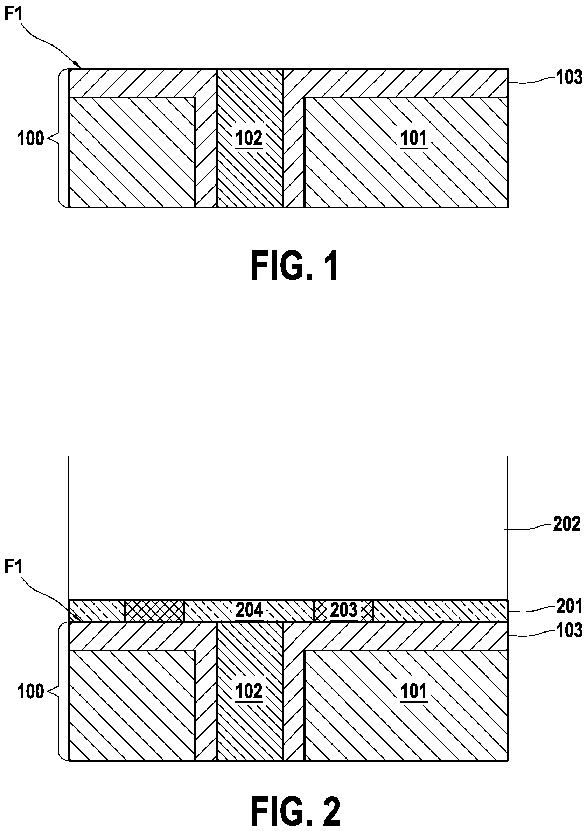

Figure 1 is a side view of a support 100 according to a first example.

Forming the support can include providing a substrate 101 (for example comprising a semiconductor material such as silicon) and forming a through conductive via (a Through Silicon Via, or TSV if the substrate 101 comprises silicon) within this substrate.

Here, the through via comprises a first conductive via 102 coming out on a face F1 of the support so as to be flush with the face F1 of the support. On the sides of the first conductive via, and at the level of the face F1 (layer 103 extends horizontally and is present everywhere on face F1 except where the first conductive via is present), the first conductive via is surrounded by an insulating region 103 (for example comprising silicon dioxide, or silicon nitride or combination of a diffusion barrier like TiN or TaN deposited onto a silicon dioxide or silicon nitride (in particular to prevent diffusion of the material of the first conductive via 102)). It should be noted that the face F1 is planar and can be optionally planarized, for example through a Chemical Mechanical Polishing (CMP) process. Preferably, there is no topology and face F1 is planar.

While not shown, the first conductive via extends throughout the substrate 101 and its lower extremity can be connected to other components or may come out on a face opposite to face F1.

Subsequently and as shown on figure 2, a layer 201 of anodization barrier material has been deposited on face F1. This anodization barrier material comprises a material which prevents the subsequent formation of pores during an anodization from penetrating further (for example by forming oxide plugs that prevent the electrolyte from penetrating further). By way of example, the layer 201 comprises tungsten. Alternatively, layer 201 can comprise a first layer having a conductivity layer having a conductive above the conductivity of tungsten (for example comprising aluminum), and a second layer comprising tungsten. Also, the layer 201 can comprise a diffusion barrier comprising, for example, titanium nitride, titanium, tantalum, or tantalum nitride to prevent any diffusion/migration (for example of the material of the first conductive via, typically copper).

Layer 201 of anodization barrier material has been patterned in the illustrated example, by a photolithography step and the openings made in layer 201 have been filled by an insulating material 203, here silicon dioxide. This allows obtaining an anodization barrier region 204 surrounded by insulating material (for example, the anodization barrier region is electrically disconnected from the remaining portions of the anodization barrier layer 201 present on the other side of the insulating portions 203 (here there is another barrier region 204' represented on the figure).

It should be noted that in the present description, the expression anodization barrier region refers to a capability of preventing anodization from extending through this region, and such a region may also have additional properties, typically if it comprises a plurality of sub-regions (or layers, these regions being stacked) such as a layer having a higher conductivity or a layer acting as diffusion/migration barrier. If an anodization barrier region comprises a plurality of sub-layers, the sub-layer which has anodization barrier properties should be in contact with the anodizable material.

It should be noted that the anodization barrier region 204 is in electrical contact with the first conductive via 102.

Preferably, the layer comprising the anodization barrier and the insulating portions is planarized, so that a subsequent formation of pores is performed on a planar surface.

Above and on the anodization barrier region, a region of anodizable material 202 has been formed. By way of example, the anodizable material is preferably aluminum. Other materials like Ta or Ti may also be used. The anodizable material is preferred because it allows forming straight vertical pores (on the figure) rather than dimples. Here, the region of anodizable material 202 can have a thickness of the order of 10 micrometers.

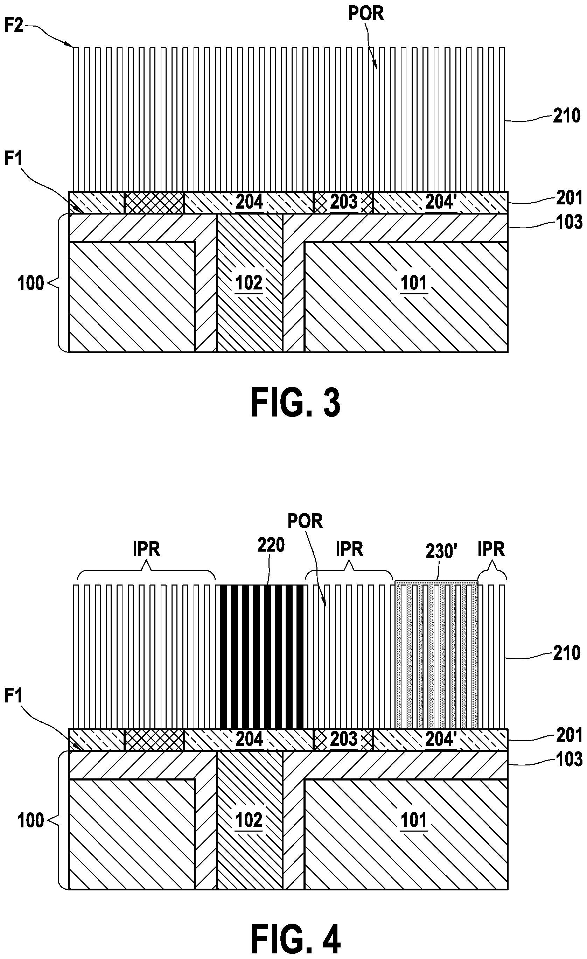

Figure 3 shows the structure of figure 2 after the region of anodizable material has been anodized to obtain a porous region 210 comprising straight vertical pores POR extending from a top surface F2 of the region to reach at least the anodization barrier region 204. Outside of the anodization barrier region, the anodizable material has also been anodized and the entire anodizable material has been replaced by straight vertical pores (here, by vertical, what is meant is that they extend in a direction which is perpendicular to face F1 (and face F2)).

It should be noted that after the anodizing has been performed, an etching of the bottom of the pores can be performed to remove, for example, oxide plugs of the material of the anodization barrier layer. Thus, all the pores open onto either the anodization barrier layer or the insulating material 203.

Subsequently, above the anodization barrier region, a second conductive via 220 has been formed by filling a first group of pores with conductive material, in a manner which is similar to the techniques used in document EP4009340. The invention is however not limited to pores being filled with conductive material and may also be implemented by etching the same group of pores to form a cavity and filling this cavity with a conductive material.

Here, the second conductive via 220 is in electrical contact with the anodization barrier region 204 and the first conductive via 102, such that a vertical connection extending throughout the device shown on the figure is obtained.

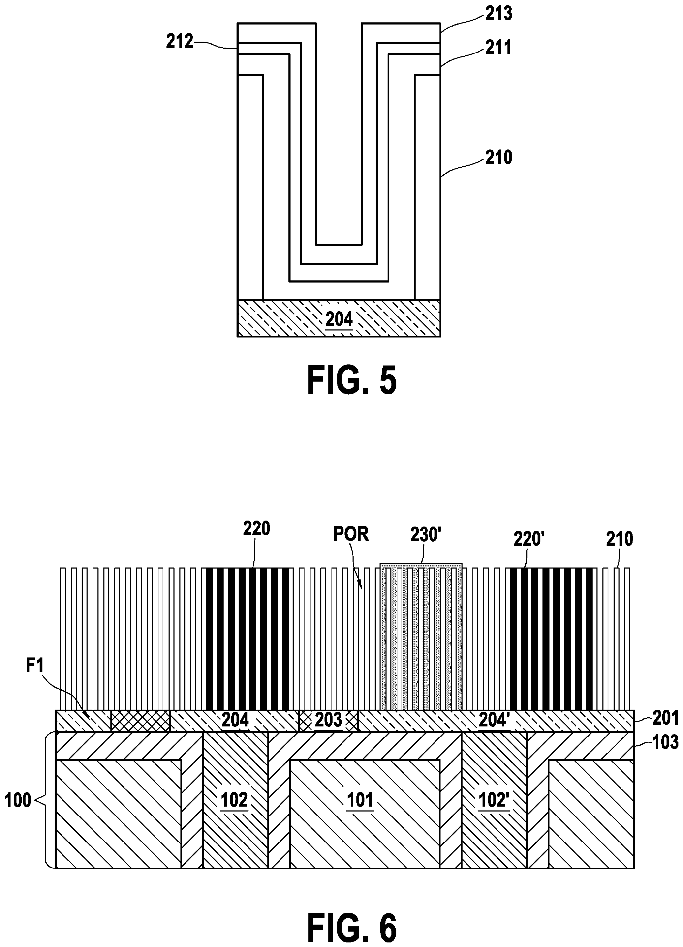

Above the another anodization barrier region 204', a MIM stack 230' has been formed. This MIM stack will be described in greater detail in reference to figure 5.

In the illustrated example, anodization barrier region 204 is electrically disconnected from the another anodization barrier region 204'. This is obtained by the patterning of the layer of anodization barrier material 201 and the presence of insulating material 203, by the presence of the insulating region 103 of the support on which the layer of anodization barrier material has been deposited (except where the first conductive via comes out), and by the pores remaining unfilled above the separation between the two anodization barrier regions.

Here, the second conductive via 220 is surrounded by pores IPR forming an insulating region as they remain empty or filled with an insulating material, and the MIM stack 230' is also surrounded by pores IPR forming an insulating region as they remain empty or filled with an insulating material.

The obtained device can be used as an interposer comprising conductive vias and a capacitor (the MIM stack 230').

Figure 5 is a close up view of a pore comprising a MIM stack such as MIM stack 230' of figure 4.

Here, the pore is formed above an anodizable barrier region 204. A bottom electrode layer 211, for example comprising titanium nitride or Platinum or Ruthenium, has been deposited in a conformal manner (for example using ALD) on the walls, on the top portions, and at the bottom of the pore so as to be in electrical contact with anodizable barrier region 204.

On the bottom electrode layer, an intermediate layer, here a dielectric layer composed from a metallic oxide, for example comprising silicon oxide or alumina or hafnium oxide or zircon oxide or a phosphorous oxide comprising ionic species like for example Li+ and doping species like N or Al, or Ti or Si to further enhance the ionic mobility, ora combination thereof, has been deposited in a conformal manner. On the intermediate layer, a top electrode layer has been deposited in a conformal manner.

This allows obtaining a MIM stack forming a capacitor.

Figure 6 is a side view of another example. The structure of this figure differs from the one of figure 4 in that the another anodization barrier region 204' is electrically connected to another first conductive via 102' having a structure analogous to the one of first conductive via 102.

Also, here, another second conductive via 220' has been formed to be in electrical contact with the another anodization barrier region 204'. The bottom electrode layer of MIM stack 230' is therefore also in contact with this another second conductive via 220', which therefore allows accessing this bottom electrode layer.

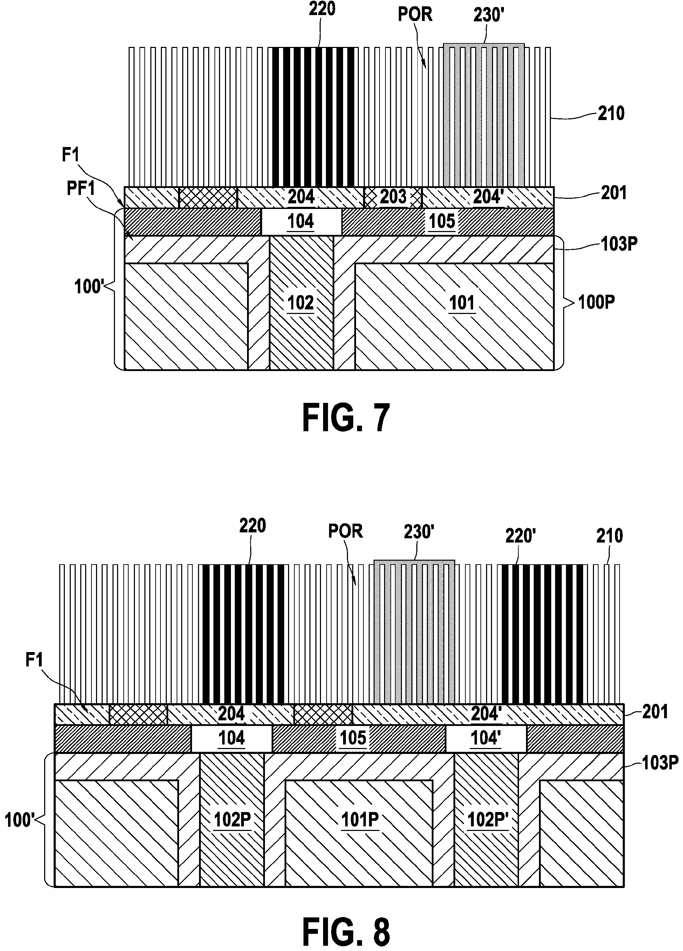

Figure 7 shows another configuration in which support 100' differs from support 100 described in reference to the previous figures.

In particular, support 100' comprises a preliminary support 100P which is analogous to support 100 and has a preliminary substrate 101P, a preliminary first conductive via 102P, and a preliminary insulating region 103P, with a preliminary face PF1.

On the preliminary face PF1, an additional insulating region 105 has been deposited, and an opening has been formed to be filled with a conductive material 104.

This allows forming an encapsulation level above the preliminary first conductive via 102P, aimed to prevent the diffusion of metallic species comprised in the preliminary first conductive via 102P into the capacitive structure. It might consist of a layer of a conductive core like Al combined with a diffusion barrier like TiN or Ti or Ta or TaN. Besides it allows another level of routing above the preliminary conductive via(s) of the device. Here, preliminary first conductive via 102P and conductive material 104 form a first conductive via connected to the second conductive via 220 represented on the figure.

Figure 8 is a side view of another example. The structure of this figure differs from the one of figure 7 in that the another anodization barrier region 204' is electrically connected to another first conductive via including a preliminary first conductive via 102P' having a structure analogous to the one of first conductive via 102P and a conductive material 104'.

In a manner which is similar to the structure of figure 6, another second conductive via 220' has been formed.

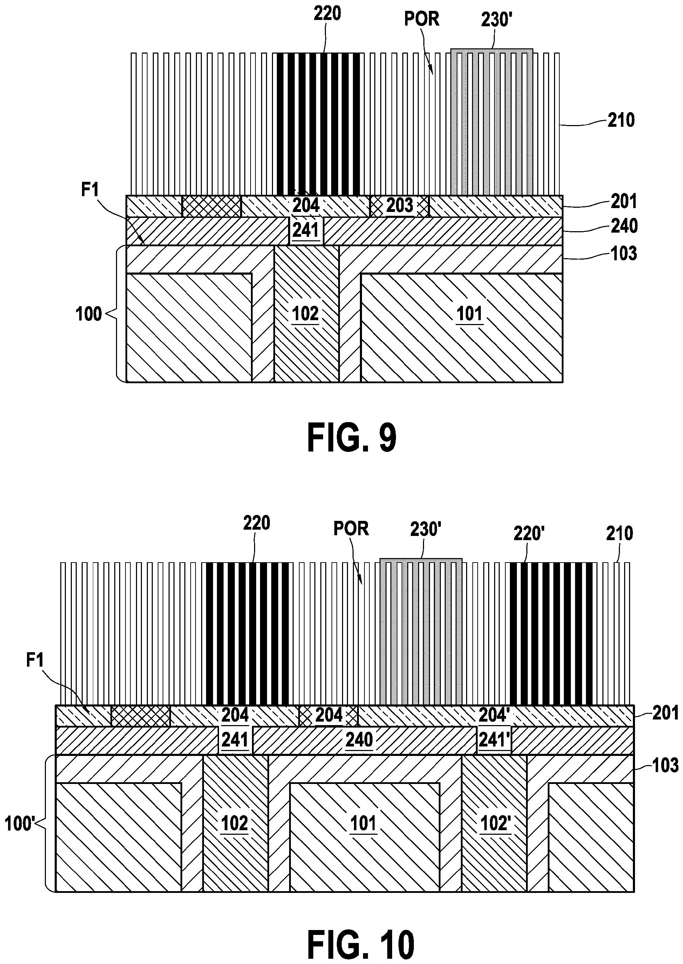

Figure 9 shows another configuration in forming the anodization barrier region differs with respect to the configuration shown on figure 2.

In particular, here, above and on a face F1 of a support 100 corresponding to the support of figures 1 to 4, another additional insulating region 240 has been formed. This region can form an encapsulation layer provided above the via, that is electrically insulating and acts as a barrier to prevent the diffusion of metallic species from first conductive via 102 into the subsequently formed capacitive structure. Layer 240 can consist of a layer of amorphous silicon nitride (SiN), or the combination of a diffusion barrier like titanium nitride (TiN) or titanium (Ti) or tantalum (Ta) or tantalum nitride (TaN) and an amorphous layer of SiN or SiO or a combination of SiN and SiO. Subsequently, an opening 241 is formed in this layer, so that the opening opens onto the first conductive via 102. The layer 241 can be made of Al or a combination of Al with a barrier layer comprising Ti, or TiN or Ta or TaN. The layer 201 of anodizable material is then deposited so as to fill this opening and also above and on the another additional insulating region 240.

Figure 10 is a side view of another example. The structure of this figure differs from the one of figure 9 in that the another anodization barrier region 204' is electrically connected to the another first conductive via through another opening 241' arranged in the another additional insulating region 240.

In a manner which is similar to the structure of figures 6 and 8, another second conductive via 220' has been formed.

It should be noted that the above described embodiments may be combined, depending on the application.

It is to be understood that references in this text to directions and locations, such as "top" and "bottom", "front" and "rear", merely refer to the directions that apply when architectures and components are oriented as illustrated in the accompanying drawings.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A method for manufacturing an integrated device, comprising:
providing a support (100) having a first conductive via (102) coming out on a face (F1) of the support so as to be flush with the face of the support, the via being surrounded by an insulating region (103) at the level of said face,
forming an anodization barrier region (204) above said face of the support, the anodization barrier layer being in electrical contact with the via,
forming a region (202) of anodizable material above the anodization barrier region and above the conductive via,
anodizing the region of anodizable material to obtain a porous region (210) comprising straight vertical pores (POR) extending from a top surface of the region to reach the anodization barrier region,
forming, within the porous region, a second conductive via (220) extending between the top surface of the porous region and the anodization barrier region, so as to form an electrical connection between the conductive via and the top surface of the porous region.

2. The method of claim 1, wherein forming the second conductive via comprises forming conductive nanowires within pores of a first group of pores of the porous region.

3. The method of claim 1, wherein forming the second conductive via comprises removing pores of a first group of pores of the porous region by etching to obtain a cavity, and filling the cavity with an electrically conductive material.

4. The method of any one of claims 1 to 3, wherein the porous region comprises first surrounding pores around the second conductive via forming an insulating region around the second conductive via.

5. The method of any one of claims 1 to 4, comprising forming another anodization barrier region above said face of the support, electrically disconnected from said anodization barrier region.

6. The method of any one of claims 1 to 5, comprising forming a stacked structure within a second group of pores of the porous region, wherein the stacked structure comprises a bottom electrode layer in electrical contact at the bottom of pores of the second group of pores with the anodization barrier region or with the another anodization barrier region, an intermediate layer on the bottom electrode layer, and a top electrode layer on the intermediate layer.

7. The method of claim 6, wherein the porous region comprises second surrounding pores around the stacked structure forming an insulating region.

8. The method of any one of claims 1 to 7, wherein providing the support comprises providing a preliminary support having a preliminary first conductive via coming out on a face of the preliminary support so as to be flush with the face of the preliminary support, the via being surrounded by an insulating region at the level of said face,
forming an additional insulating region on the face of the preliminary support having an opening that opens onto the preliminary first conductive via, and filling the opening with a conductive material, the preliminary first conductive via and the conductive material filling the opening forming the first conductive via.

9. The method of any one of claims 1 to 8, wherein forming the anodization barrier region comprises forming, on said face of the support, another additional insulating region having an opening that opens onto the first conductive via, and depositing a layer of anodization barrier material on the another additional insulating region and inside the opening of the another additional insulating region to obtain the anodization barrier region.

10. The method of any one of claims 1 to 9, comprising performing a planarizing to obtain said face of the support.

11. An integrated device comprising:
a support (100) having a first conductive via (102) coming out on a face (F1) of the support so as to be flush with the face of the support, the via being surrounded by an insulating region (103) at the level of said face,
an anodization barrier region (204) above said face of the support, the anodization barrier layer being in electrical contact with the via,
a porous region (210) above the anodization barrier region comprising straight vertical pores (POR) extending from a top surface of the region to reach the anodization barrier region,
within the porous region, a second conductive via (220) extending between the top surface of the porous region and the anodization barrier region, so as to form an electrical connection between the conductive via and the top surface of the porous region.

12. The integrated device of claim 11, wherein the second conductive via comprises conductive nanowires within pores of a first group of pores of the porous region.

13. The integrated device of claim 11, wherein the second conductive via comprises a cavity having a width which is greater than a pore of the porous region, filled with an electrically conductive material.

14. The integrated device of any one of claims 11 to 13, wherein the porous region comprises first surrounding pores around the second conductive via forming an insulating region around the second conductive via.

15. The integrated device of any one of claims 11 to 14, comprising another anodization barrier region above said face of the support, electrically disconnected from said anodization barrier region.
